**Europäisches Patentamt**

**European Patent Office**

**Office européen des brevets**

(19)

(11) Numéro de publication: **0 087 336**
**B1**

(12) # FASCICULE DE BREVET EUROPÉEN

(45) Date de publication du fascicule du brevet:
**23.07.86**

(51) Int. Cl.⁴: **H 03 D 7/12**

(21) Numéro de dépôt: **83400222.2**

(22) Date de dépôt: **02.02.83**

(54) **Mélangeur à transistor pour émetteurs hyperfréquences.**

(30) Priorité: **12.02.82 FR 8202346**

(43) Date de publication de la demande:
**31.08.83 Bulletin 83/35**

(45) Mention de la délivrance du brevet:
**23.07.86 Bulletin 86/30**

(84) Etats contractants désignés:
**DE FR GB IT**

(56) Documents cité:
**DE-A-2 147 559**
**FR-A-1 145 253**
**US-A-3 040 255**

**GTH EUROPEAN MICROWAVE CONFERENCE,
ROME 14-17 septembre 1976, pages 8-13, Seven
Oaks, GB. P. HARROP et al.: "Performance of some
GaAs mesfet mixers"
IEEE MTT-S INTERNATIONAL MICROWAVE
SYMPOSIUM, Cherry Hill, 14-16 juin 1976, pages 90-
92, Piscataway, USA P. BURA et al.: "FET mixers
for communication setallite transponders"
RADIOMENTOR ELECTRONIC, vol. 42, no. 6, juin
1976, pages 220-222, Munich, DE. K. KRAJENSKI:
"Mischteil mit pin-Dioden-Regelung für HiFi-
Spitzengeräte"
FUNKSCHAU, vol. 38, no. 22, 2 novembre 1966,
pages 685-687, Munich, DE. H. DEMTRÖDER et al.:**

(73) Titulaire: **THOMSON- CSF, 173, Boulevard
Haussmann, F-75379 Paris Cedex 08 (FR)**

(72) Inventeur: **Bensussan, André, THOMSON- CSF
SCPI 173, Bld Haussmann, F-75379 Paris Cedex 08
(FR)**
Inventeur: **Birot, Patrice, THOMSON- CSF SCPI
173, Bld Haussmann, F-75379 Paris Cedex 08 (FR)**
Inventeur: **Curtinot, Jean- Claude, THOMSON- CSF
SCPI 173, Bld Haussmann, F-75379 Paris Cedex 08
(FR)**
Inventeur: **Van Kerrebroeck, Claude, THOMSON-
CSF SCPI 173, Bld Haussmann, F-75379 Paris
Cedex 08 (FR)**

(74) Mandataire: **Weinmiller, Jürgen, Zeppelinstrasse
63, D-8000 München 80 (DE)**

(56) Documents cité: (suite)
**"UKW-Tuber mit Feldeffekt-Transistoren"**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

# Description

La présente invention concerne un mélangeur à transistor pour émetteurs hyperfréquences.

On entend par mélangeur un dispositif électronique qui assure le mélange de deux signaux périodiques de fréquences différentes pour délivrer un signal unique dont le spectre de fréquence contient au moins une fréquence égale à la somme ou à la différence des fréquences des deux signaux qui lui sont appliqués.

Une solution classique pour réaliser les mélangeurs hyperfréquences consiste à utiliser des diodes Schottky au silicium ou à l'arséniure de gallium. Ces diodes comportent une jonction métal semiconducteur faiblement dopée qui autorise leur fonctionnement à des fréquences très élevées, supérieures à 1 GHz. Les pertes de conversion des mélangeurs à diode Schottky, correspondant à la différence en décibels de la puissance disponible à leur entrée et de celle disponible en leur sortie, pourraient être en théorie à peu près nulles, si leurs sorties étaient parfaitement adaptées aux fréquences des raies du spectre du signal obtenu en sortie et si toutes les puissances des raies non essentielles du spectre étaient récupérées.

Or, dans la pratique il est impossible de contrôler toutes les impédances de terminaison d'un mélangeur pour chaque fréquence. La seule fréquence contrôlable est la fréquence image de la fréquence du signal reçu à l'entrée du mélangeur par rapport à l'autre fréquence. La fréquence somme résultant de la somme des fréquences des deux signaux appliqués à l'entrée est, dans les dispositifs récepteurs par exemple, très élevée et est généralement incontrôlable. Par conséquent, les pertes de conversion d'un mélangeur à diode Schottky ne sont pas nulles et comme généralement on doit associer au mélangeur un amplificateur placé avant ou après celui-ci, pour obtenir un signal exploitable, les pertes de conversion du mélangeur s'ajoutent au facteur de bruit de l'amplificateur auquel il est couplé. En pratique on relève des facteurs de bruit de 4 à 8 décibels dans les récepteurs d'onde électromagnétique comportant des mélangeurs à diode Schottky couplés à leur amplificateur. Au niveau de la réalisation des émetteurs, les pertes de conversion nécessitent une augmentation de la puissance de l'oscillateur local, ce qui augmente en conséquence l'énergie consommée par l'oscillateur. Dans certains applications, comme par exemple la réalisation de satellites de télécommunications, l'augmentation de l'énergie consommée se traduit par un dimensionnement plus important des générateurs de production d'énergie électrique.

Pour diminuer les pertes de conversion, certains mélangeurs hyperfréquences sont réalisés à l'aide de transistors unipolaires à effet de champ du type MESFET dont la grille de commande est constituée par une diode Schottky. Malgré la résistance série élevée que présente la diode Schottky de ces transistors, l'atténuation qui en résulte, est en partie compensée par le gain des transistors à leur fréquence d'utilisation. Par ailleurs chacun de ces transistors agit en commutateur et la variation de son gain en fonction du niveau des signaux appliqués permet d'obtenir un mélange dont le niveau dépend du gain du transistor. Toutefois le gain obtenu n'est généralement pas suffisant et ce type de réalisation nécessite souvent la mise en place d'un amplificateur placé en amont et en aval du transistor mélangeur hyperfréquences. Ce mauvais résultat s'explique en partie par le fait que la zone de fonctionnement, dans le plan des caractéristiques de courant drain-source en fonction de la tension drainsource, du transistor MESFET est limitée à l'intérieur d'un petit parallélogramme, dont les dimensions des côtés sont liées à l'excursion $V_g$ de la tension de chacun des signaux appliqués sur la grille du transistor et dont l'angle d'inclinaison est lié à la différence des pentes des deux droites de charge du transistor correspondant à chacune des fréquences des signaux appliqués sur sa grille. Pour augmenter le rendement dans ce type de réalisation on cherche naturellement à augmenter la surface du parallélogramme mais on est rapidement limité par l'apparition d'un courant grille qui est destructif pour le transistor.

Le but de l'invention est de pallier les inconvénients précités à l'aide d'un dispositif qui permette une excursion maximum des régions non-linéaires des transistors utilisés, de façon à améliorer le gain de conversion des mélangeurs hyperfréquences.

A cet effet l'invention a pour objet un mélangeur à transistor pour émetteurs hyperfréquences, destiné à mélanger un signal fourni par un oscillateur local à un signal utile de fréquence intermédiaire, de manière à obtenir un signal mélangé dont le spectre de fréquence contient la somme ou la différence des fréquences, respectivement, du signal fourni par l'oscillateur local et du signal utile de fréquence intermédiaire, comprenant au moins un transistor unipolaire du type FET ayant une électrode de grille, une électrode de drain et une électrode de source, des premiers moyens pour assurer une polarisation statique du transistor, des deuxièmes moyens pour appliquer un premier signal sur l'electrode de grille, des troisièmes moyens pour appliquer un deuxième signal sur une des deux autres électrodes de drain ou de source et des quatrième moyens pour prélever le signal résultant du mélange sur l'électrode de drain ou de source sur laquelle le deuxième signal est appliqué, comme connu par le DE—A—2 147 559, le selon mélangeur l'invention étant caractérisé en ce que le transistor unipolaire est de type MESFET, en ce que lesdits premiers moyens comportent une source de tension continue et une résistance placés en série dans le circuit de grille du transistor de manière à assurer la polarisation statique dudit transistor dans une zone de conduction non-linéaire de celui-ci, en ce que le premier signal est fourni par l'oscillateur local, en ce que le deuxième signal est le signal à fréquence intermédiaire, et en ce que l'électrode de drain ou de source non alimentée par les troisièmes moyens est reliée à la masse générale d'alimentation en énergie continue du mélangeur.

D'autres caractéristiques et avantages de l'invention apparaîtront au cours de la description faite au regard des dessins annexés, donnés uniquement à titre d'exemples et dans lesquels:

Les figures 1 à 6 représentent des exemples de réalisation de mélangeurs à modulation par le drain.

La figure 7 représente un exemple de réalisation d'un mélangeur à modulation par l'électrode de source.

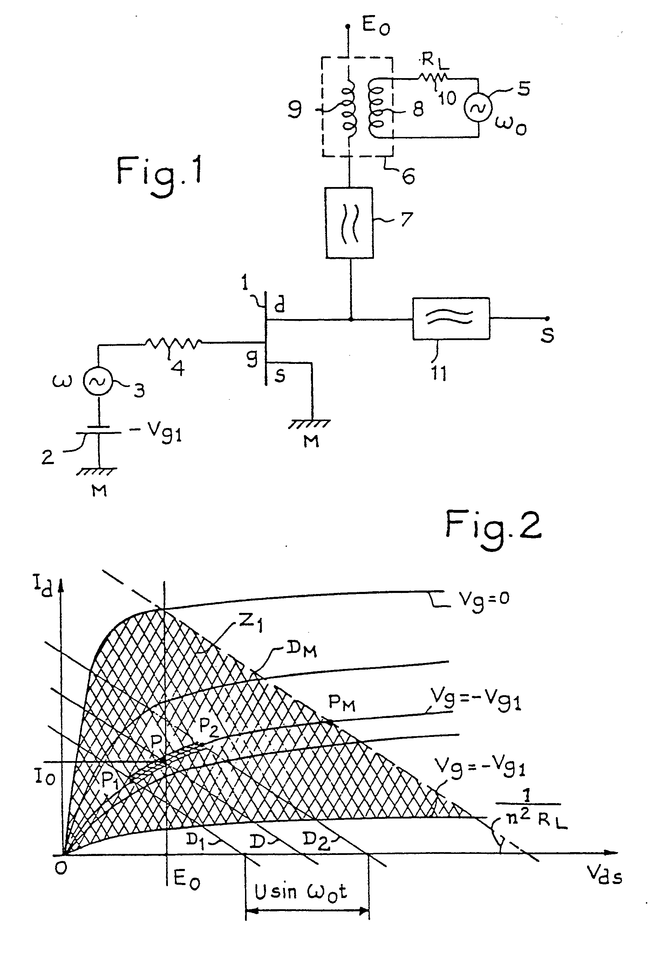

Le dispositif mélangeur de la figure 1 comprend un transistor unipolaire 1 du type MESFET comprenant une électrode de source s reliée au plan de masse du dispositif, une électrode de drain d, et une électrode de grille g. L'électrode de grille est polarisée par un générateur 2 de tension continue $-V_{g1}$ au travers, d'un générateur 3 de tension alternative de pulsation $\omega$ ayant la fonction d'oscillateur local et d'une résistance 4 montée en série. L'électrode de drain est polarisée par une tension continue $E_0$ qui est appliquée sur le drain au travers d'un transformateur 6 et d'un filtre haute fréquence 7. Le transformateur 6 qui est utilisé ici en tant que modulateur de la tension de drain, comprend un enroulement primaire 8 et un enroulement secondaire 9. L'enroulement primaire 8 est alimenté par une tension alternative de pulsation $\omega_0$ fournissant le signal de fréquence intermédiaire au travers d'une résistance 10. L'enroulement secondaire 9 est connecté par une extrémité à la source de tension continue $E_0$ et par son autre extrémité à une extrémité du filtre 7. L'autre extrémité du filtre 7 est connectée à l'électrode de drain du transistor 1. L'électrode de drain du transistor 1 est connectée à la sortie S du dispositif au travers du filtre haute fréquence 11.

Le fonctionnement du dispositif mélangeur réprésenté à la figure 1 est maintenant décrit à l'aide du diagramme de la figure 2 représentant les déplacements de la droite de charge du transistor 1 dans le plan des caractéristiques $I_d > f(V_{ds})$ du transistor pour différentes valeurs de la tension grille $V_g$. $I_d$ est le courant drain-source et $V_{ds}$ est la tension entre l'électrode de drain et l'électrode de source du transistor 1. Le point statique P de polarisation du transistor, en l'absence de modulation par les tension alternatives appliquées sur la grille et sur le drain, est situé à l'intersection de la courbe caractéristique $I_d = f(V_{ds})$ pour la tension $-V_{g1}$ de polarisation de la grille et de la droite orthogonale à l'axe $V_{ds}$ passant le point $V_{ds} = E_0$ qui représente la tension d'alimentation continue du drain du transistor 1. Au point de polarisation P correspond un courant statique $I_0$ sur la droite $I_d$. Si n est le rapport de transformation entre le primaire 8 et le secondaire 9 du transformateur 6 et si $R_L$ est la valeur de la résistance 10, la résistance ramenée au secondaire 9 du transformateur est égale à $n^2 \times R_L$. Cette résistance ramenée détermine la pente de la droite de charge dynamique du transistor 1. Au cours de la modulation de la tension du drain du transistor 1 par la source de tension 5 de pulsation $\omega_0$, la droite de charge dynamique D se déplace parallèlement à ellemême et le point P occupe alternativement les positions $P_1$ et $P_2$ sur la caractéristique $-V_{g1}$ lorsqu'il n'existe pas de modulation sur la grille du transistor. L'amplitude de déplacement du point P dépend naturellement de l'amplitude de la tension alternative délivrée par le générateur 5. Cette amplitude peut être tres grande et le point P peut balayer la caractéristique $-V_{g1}$ depuis le point 0 de coordonnées $I_d = 0$ et $V_{ds} = 0$ jusqu'à un point maximum $P_M$ situé sur la courbe caractéristique $V_g = -V_{g1}$ au début de la partie linéaire de cette courbe. Le point $P_M$ est naturellement situé sur une droite $D_M$ de pente

$$\frac{-1}{n^2 R_L}.$$

On s'aperçoit immédiatement, lorsque la tension grille du transistor 1 est modulée par la tension alternative délivrée par le générateur 3, que le point P se déplace à l'intérieur d'une zone $Z_1$. La zone $Z_1$ est située à l'intérieur d'un contour défini par la droite $D_M$, la caractéristique $I_d = f(V_{ds})$ pour $V_g = 0$ volt et la caractéristique $I_d = f(V_{ds})$ pour la tension grille $V_g = -V_p$ correspondant à la tension de pincement au-delà de laquelle un courant inverse trop grand peut provoquer la destruction du transistor 1.

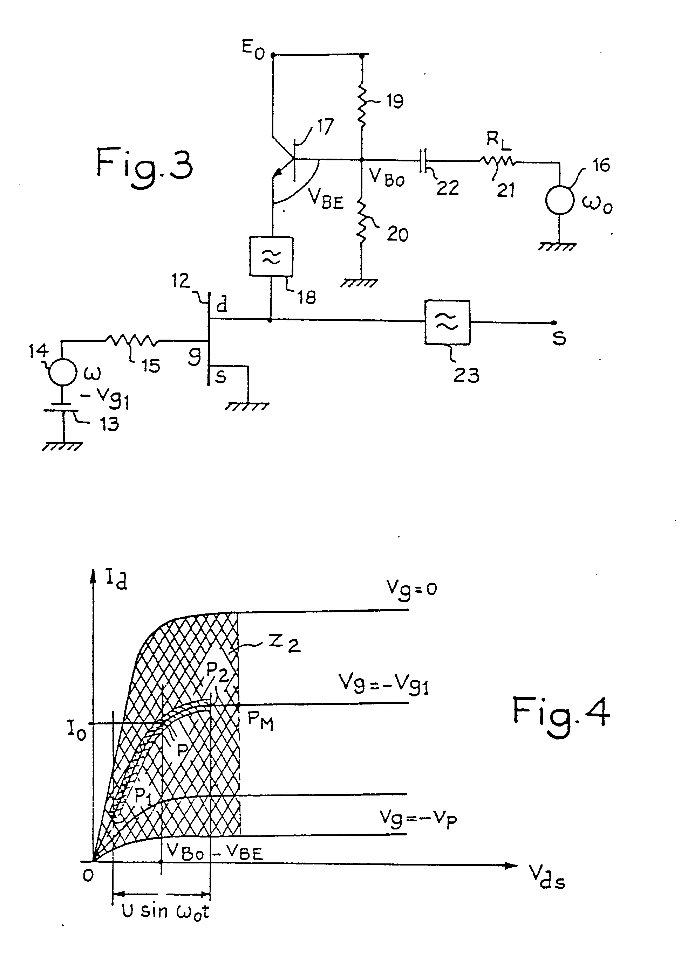

Un deuxième exemple de réalisation du mélangeur selon l'invention est représenté à la figure 3. Sur cette figure le mélangeur comprend un transistor unipolaire 12 du type MESFET composé comme précédemment d'une grille g, d'un drain d, et d'une source s. La source s est reliée à la masse du dispositif. La grille est polarisée par une tension continue $-V_{g1}$ délivrée par une source de tension continue 13 au travers d'un générateur de tension alternative 14 de pulsation $\omega$ ayant la fonction d'oscillateur local et d'une résistance 15 montée en série. L'électrode de drain d est modulée par une tension alternative délivrée par un générateur 16 de fréquence intermédiaire au travers d'un transistor 17 qui est utilisé ici en tant que modulateur de la tension de drain. Le transistor 17 a son collecteur relié à une tension d'alimentation continue $E_0$ et son émetteur est relié au drain du transistor 12 au travers d'une filtre haute fréquence 18. La base du transistor 17 est polarisée à l'aide d'un diviseur potentiomètrique formé des résistances 19 et 20 qui est connecté à la sortie de la source d'alimentation continue $E_0$. La tension alternative délivrée par le générateur 16 est appliquée à la base du transistor 17 au travers d'une résistance 21 et d'un condensateur 22 montés en série. Le drain du transistor 12 est également connecté à la sortie du dispositif mélangeur au travers d'un filtre 23.

Le fonctionnement du dispositif représenté à la figure 3 est expliqué ci-après à l'aide du graphique de la figure 4. Dans ce montage la tension de modulation délivrée par le générateur 16 est appliquée à l'électrode de drain du transistor 12 au travers d'un transistor monté en émetteur-suiveur. Par conséquent la tension de polarisation statique du drain du transistor 12 est égale à la tension $V_{B0}$ apparaisant aux bornes de la résistance 20 du diviseur potentiomètrique formé des résistances 19 et 20, retranchée de la tension $V_{BE}$ apparaissant entre la base et l'émetteur du transistor 17. Comme le transistor 12 est polarisé sur sa grille par la tension continue $-V_{g1}$, le courant statique traversant le transistor 12 est le courant $I_0$ qui apparaît sur les courbes caractéristiques $I_d=f(V_{ds})$ du transistor 12 à l'intersection de la droite orthogonale à l'axe $V_{ds}$ passant par le point $V_{B0}-V_{BE}$ situé sur l'axe $V_{ds}$ et de la courbe $I_d=f(V_{ds})$ pour la tension $-V_{g1}$ de polarisation de la grille. Le point P, de coordonnées $I_d=I_0$ et $V_{B0}-V_{BE}$ qui en résulte, est le point de polarisation statique du transistor 12. Le point P en l'absence de tension alternative développée sur la grille du transistor 12 se déplace entre les points $P_1$ et $P_2$ de la caractéristique de $I_d=f(V_{ds})$ correspondant à la polarisation de grille égale à $-V_{g1}$, au rythme de l'oscillation de la tension alternative délivrée par le générateur 16. Comme dans le cas de la figure 2, il est possible de faire déplacer le point P sur la courbe caractéristique correspondant à la tension $-V_{g1}$ entre le point 0 des caractéristiques pour lesquelles le courant $I_d=0$ et la tension $V_{ds}=0$ et un point maximum $P_M$ situé à la frontière de la partie non-linéaire et de la partie linéaire de la courbe caractéristique correspondant à la tension $-V_{g1}$ de polarisation de la grille. On en déduit par conséquent, lorsque l'on applique simultanément une tension de modulation sur la grille du transistor 12 et une autre tension de modulation sur son drain, que la zone de travail du mélangeur de la figure 3 est située à l'intérieur de la zone $Z_2$ délimitée par la droite orthogonale à l'axe $V_{ds}$ passant le point $P_M$, de la courbe caractéristique $I_d=f(V_{ds})$ du transistor 12 pour la tension grille $V_g=0$ et de la courbe caractéristique $I_d=f(V_{ds})$ du transistor 12 pour la tension grille $V_g=-V_p$ correspondant à la tension de pincement du transistor 12. Comme dans le cas du dispositif représenté à la figure 1, le mode de polarisation du dispositif de la figure 3 permet également un balayage complet de la zone non-linéaire du transistor 12.

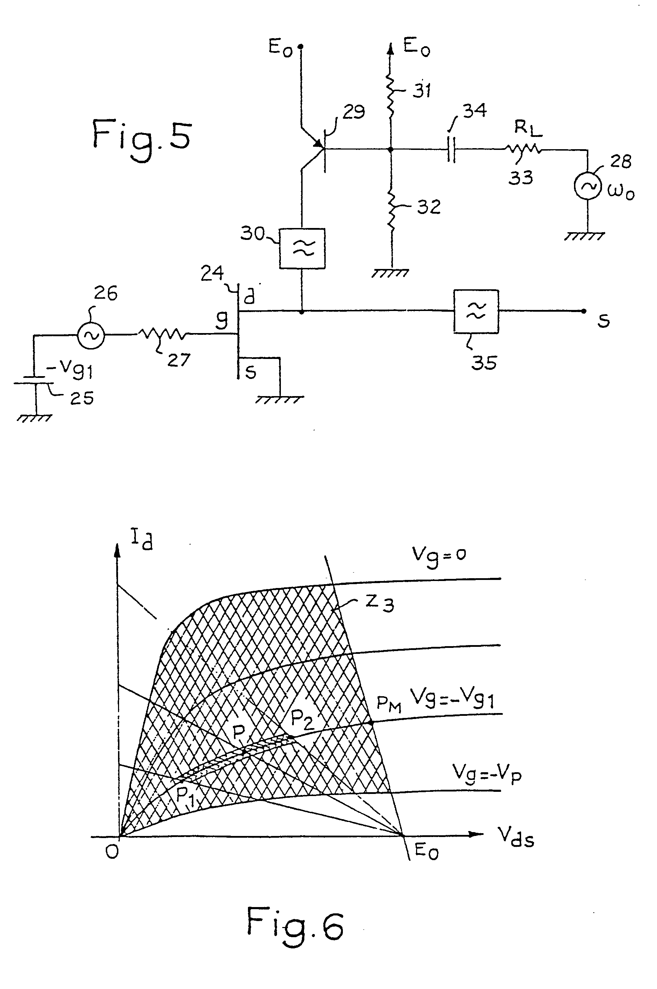

Dans la variante de réalisation de la figure 5 la pente de la droite de charge du transistor unipolaire est rendue variable au rythme d'une des deux fréquences appliquées sur le mélangeur. Le dispositif, représenté à la figure 5 comprend un transistor unipolaire 24 du type MESFET, polarisé sur son électrode de grille par une tension continue $-V_{g1}$, délivrée par un générateur 25. L'électrode de grille g est alimentée par une source de tension alternative 26 formant oscillateur local au travers d'une résistance 27. Le transistor 24 est alimenté sur son drain par une source de tension alternative 28 fournissant la fréquence intermédiaire, de pulsation $\omega_0$, au travers d'un modulateur de la tension de drain composé d'un transistor PNP 29, monté en émetteur commun et dont l'émetteur est relié à une source de tension continue $E_0$. Le collecteur du transistor 29 est relié au drain du transistor 24 au travers d'un filtre 30. La base du transistor 29 est polarisée par un diviseur potentiomètrique, formé des résistances 31 et 32 qui est alimenté par la source de tension continue $E_0$. La base du transistor 29 est également reliée à la sortie du générateur de tension alternative 28 au travers d'une résistance 33 et d'un condensateur 34 montés en série. Le drain du transistor 24 est également connecté à la sortie du dispositif mélangeur au travers du filtre 35.

Dans le cas de la figure 5 la droite de charge du transistor 24 est constituée par la résistance émetteur-collecteur du transistor 29 et la valeur de cette résistance varie en fonction de la valeur de la tension alternative appliquée sur sa base. Par conséquent, le point statique de polarisation du transistor 24 varie, comme dans les cas précédents, entre les points $P_1$ et $P_2$ de la caractéristique $I_d=f(V_{ds})$ pour la tension grille $V_g=-V_{g1}$. Lorsque, le générateur 26 applique une tension alternative sur la grille du transistor 24, le point P de polarisation se déplace à l'intérieur d'une zone $Z_3$ en fonction de l'amplitude des tension alternatives appliquées sur la grille et sur le drain du transistor 24. La zone $Z_3$ est déterminée par une droite de charge reliant le point $E_0$ de la droite $V_{ds}$ à un point $P_M$ de la caractéristique $I_d=f(V_{ds})$ pour la tension grille $V_g=-V_{g1}$ située comme précédemment à la frontière de la partie linéaire et de la partie non-linéaire de cette courbe caractéristique et d'autre part, entre les courbes caractéristiques de $I_d=f(V_{ds})$ tracées pour la tension grille $V_g=0$ volt et de la courbe caractéristique tracée pour la tension grille de pincement égale à $-V_p$.

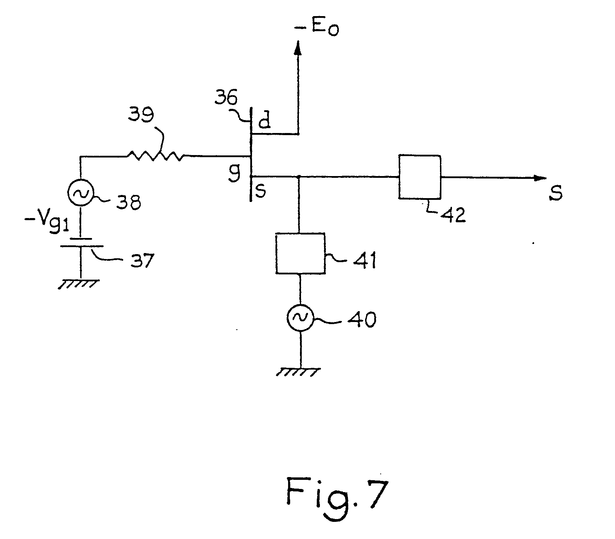

Bien que dans les exemples de réalisation de l'invention qui viennent d'être décrits, l'électrode de source du transistor mélangeur soit connectée au plan de masse et qu'une tension alternative soit appliquée à son électrode de drain, on concevra qu'il est tout aussi possible, dans d'autres modes de réalisation, d'inverser le rôle des électrodes de drain et de source comme dans l'exemple représenté à la figure 7. Sur cette figure, la grille du transistor 36 est polarisée, comme dans les montages précédents, par une tension continue $-V_{g1}$ délivrée par un générateur 37 et est alimentée par une source de tension alternative 38 formant oscillateur local au travers d'une résistance 39. Contrairement aux exemples de réalisation précédents, l'électrode de drain du transistor 36 est reliée à une source de tension continue $-E_0$ et l'électrode de source est reliée à une source de tension alternative 40 fournissant la fréquence intermédiaire au travers d'un filtre haute fréquence 41. Un filtre 42 relie l'electrode de source du transistor 36 à la sortie S du dispositif.

## Revendications

1. Mélangeur à transistor pour émetteurs hyperfréquences, destiné à mélanger un signal fourni par un oscillateur local à un signal utile de fréquence intermédiaire, de manière à obtenir un signal mélangé(s) dont le spectre de fréquence contient la somme ou la différence des fréquences respectivement du signal fourni par l'oscillateur local et du signal utile de fréquence intermédiaire, comprenant au moins un transistor unipolaire du type FET ayant une électrode de grille une électrode de drain et une électrode de source, des premiers moyens (2, 4; 13, 15; 25, 27; 37, 39) pour assurer une polarisation statique du transistor, des deuxièmes moyens (4, 15, 27, 39) pour appliquer un premier signal (3, 14, 26, 38) sur l'électrode de grille, des troisièmes moyens (6, 17, 29, 41) pour appliquer un deuxième signal (5, 16, 28, 40) sur une des deux autres électrodes de drain ou de source et des quatrièmes moyens (11, 23, 25, 42) pour prélever le signal résultant du mélange sur l'électrode de drain ou de source sur laquelle le deuxième signal est appliqué, caractérisé en ce que ledit transistor unipolaire est du type MESFET, en ce que lesdits premiers moyens comportent une source de tension continue (2, 13, 25, 37) et une résistance (4, 15, 27, 39) placés en série dans le circuit de grille du transistor de manière à assurer ladit polarisation statique dudit transistor dans une zone de conduction non linéaire de celui-ci, en ce que le premier signal est fourni par l'oscillateur local, en ce que le deuxième signal est le signal à fréquence intermédiaire, et en ce que l'électrode du drain ou de source non alimentée par les troisièmes moyens est reliée à la masse générale d'alimentation en énergie continue du mélangeur.

2. Mélangeur selon la revendication 1, caractérisé en ce que les troisièmes moyens (6, 17, 29) comprennent un modulateur de la tension appliquée sur l'une des deux autres électrodes.

3. Mélangeur selon les revendications 1 et 2, caractérisé en ce que le modulateur est constitué par un transformateur (6) dont l'enroulement primaire (8) est alimenté par le deuxième signal périodique de fréquence intermédiaire et dont l'enroulement secondaire (9) alimente l'une des deux autres électrodes.

4. Mélangeur selon les revendications 1 et 2, caractérisé en ce que le modulateur est constitué par un transistor émetteur-suiveur (17) dont l'émetteur est relié à l'une des deux autres électrodes du transistor mélaneur et dont la base est alimentée par le deuxième signal périodique de fréquence intermédiaire.

5. Mélangeur selon les revendications 1 et 2, caractérisé en ce que le modulateur est constitué par un transistor à émetteur commun (29) dont le collecteur est relié à l'une des deux autres électrodes de drain ou de source du transistor mélangeur et dont la base est alimentée par le deuxième signal périodique de fréquence intermédiaire.

6. Mélangeur selon l'une quelconque des revendications 1 à 5, caractérisé en ce que les troisièmes moyens appliquent le deuxième signal périodique de fréquence intermédiaire sur l'électrode de drain du transistor mélangeur.

7. Mélangeur selon la revendication 1, caractérisé en ce que les troisièmes moyens appliquent le deuxième signal périodique de fréquence intermédiaire sur l'électrode de source du transistor mélangeur.

## Patentansprüche

1. Transistorisierter Mischer für Mikrowellensender, mit dem ein von einem örtlichen Oszil' 'or geliefertes Signal mit einem Zwische: 'e- quenz-Nutzsignal gemischt werden kann, so daß sich ein gemischtes Signal (S) ergibt, dessen Frequenzspektrum die Summe oder Differenz der Frequenzen des vom örtlichen Oszillator gelieferten Signals und des Zwischenfrequenz-Nutzsignals enthält, mit mindestens einem FET-Unipolartransistor, der eine Gitterelektrode, eine Drainelektrode und eine Sourceelektrode aufweist, mit ersten Mitteln (2, 4; 13, 15; 25, 27; 37, 39), um eine statische Vorspannung des Transistors zu bewirken mit zweiten Mitteln (4, 15, 27, 39), um ein erstes Signal (3, 14, 26, 38) an die Gitterelektrode anzulegen, mit dritten Mitteln (6, 17, 29, 41), um ein zweites Signal (5, 16, 28, 40) an eine der restlichen Elektroden, nämlich die Drainelektrode oder die Sourceelektrode, anzulegen, und mit vierten Mitteln (11, 23, 25, 42), um das aus der Mischung resultierende Signal an der Drain- oder Sourceelektrode, an die das zweite Signal angelegt wird, abzunehmen, dadurch gekennzeichnet, daß der Unipolartransistor ein MESFET-Transistor ist, daß die ersten Mittel eine Gleichspannungsquelle (2, 13, 25, 37) und einen Widerstand (4, 15, 27, 39) aufweisen, die in Reihe im Gitterschaltkreis des Transistors liegen und die statische Vorspannung des Transistors in einer nichtlinearen Leitzone des Transistors bewirken, daß das erste Signal vom örtlichen Oszillator geliefert wird, daß das zweite Signal das Zwischenfrequenzsignal ist und daß die von den dritten Mitteln nicht gespeiste Elektrode, d.h. die Drain- oder die Sourceelektrode, an die allgemeine Gleichstromversorgungsmasse des Mischers angeschlossen ist.

2. Mischer nach Anspruch 1, dadurch gekennzeichnet, daß die dritten Mittel (6, 17, 29) einen Modulator für die an eine der beiden restlichen Elektroden angelegte Spannung enthalten.

3. Mischer nach den Ansprüchen 1 und 2, dadurch gekennzeichnet, daß der Modulator von einem Transformator (6) gebildet wird, dessen Primärwicklung (8) mit dem zweiten periodischen Zwischenfrequenzsignal gespeist wird und dessen Sekundärwicklung (9) eine der beiden restlichen Elektroden speist.

4. Mischer nach den Ansprüchen 1 und 2, dadurch gekennzeichnet, daß der Modulator von einem Emitterfolgertransistor (17) gebildet wird, dessen Emitter an eine der beiden restlichen Elektroden des Mischtransistors angeschlossen ist und dessen Basis das zweite periodische Zwischenfrequenzsignal zugeführt erhält.

5. Mischer nach den Ansprüchen 1 und 2, dadurch gekennzeichnet, daß der Modulator von einem Transistor (29) in Emitterbasisschaltung gebildet wird, dessen Kollektor an eine der beiden restlichen Elektroden des Mischtransistors, nämlich die Drain- oder die Sourceelektrode, angeschlossen ist und dessen Basis mit dem zweiten periodischen Zwischenfrequenzsignal gespeist wird.

6. Mischer nach einem beliebigen der Ansprüche 1 bis 5, dadurch gekennzeichnet, daß die dritten Mittel das zweite periodische Zwischenfrequenzsignal an die Drainelektrode des Mischtransistors anlegen.

7. Mischer nach Anspruch 1, dadurch gekennzeichnet, daß die dritten Mittel das zweite periodische Zwischenfrequenzsignal an die Sourceelektrode des Mischtransistors anlegen.

**Claims**

1. A transistorized mixer for microwave transmitters conceived to mix a signal supplied by a local oscillator with a useful intermediate frequency signal so as to obtain a mixed signal (S) whose frequency spectrum contains the sum or the difference of the frequencies respectively of the signal supplied by the local oscillator and of the useful intermediate frequency signal, the mixer comprising at least one unipolar FET transistor having a gate electrode, a drain electrode and a source electrode, first means (2, 4; 13, 15; 25, 27; 37, 39) for providing a static biassing of the transistor, second means (4, 15, 27, 39) for applying the first signal (3, 14, 26, 38) to the gate electrode, third means (6, 17, 29, 41) for applying a second signal (5, 16, 28, 40) to one of the two remaining electrodes, i.e. the drain or the source electrode, and fourth means (11, 23, 25, 42) for taking the signal resulting from the mixing at the drain or the source electrode to which the second signal is applied, characterized in that said unipolar transistor is a MESFET transistor, that the first means include a DC voltage source (2, 13, 25, 37) and a resistor (4, 15, 27, 39), which are arranged in series in the gate circuit of the transistor so as to ensure said static biassing of said transistor in a non-linear conduction zone of the latter, that the first signal is supplied by the local oscillator, that the second signal is the intermediate frequency signal and that the drain or source electrode which is not fed by the third means, is connected to the general earth terminal of the DC power supply of the mixer.

2. A mixer according to claim 1, characterized in that the third means (6, 17, 29) include a modulator for modulating the voltage applied to one of the two remaining electrodes.

3. A mixer according to claims 1 and 2, characterized in that the modulator is formed by a transformer (6), the primary winding (8) of which is fed with the second periodic intermediate frequency signal whereas the secondary winding (9) feeds one of the two remaining electrodes.

4. A mixer according to claims 1 and 2, characterized in that the modulator is formed of an emitter follower transistor (17) whose emitter is connected to one of the two remaining electrodes of the mixer transistor and whose base is fed by the second peroidic intermediate frequency signal.

5. A mixer according to claims 1 and 2, characterized in that the modulator is formed of a common emitter transistor whose collector is connected to one of the two remaining electrodes, the drain or the source electrode, of the mixer transistor, and whose base is fed by the second periodic intermediate frequency signal.

6. A mixer according to any one of claims 1 to 5, characterized in that the third means apply the second periodic intermediate frequency signal to the drain electrode of the mixer transistor.

7. A mixer according to claim 1, characterized in that the third means apply the second periodic intermediate frequency signal to the source electrode of the mixer transistor.

Fig.1

Fig.2

# Fig.3

# Fig.4

Fig.5

Fig.6

Fig.7